# DEMANDE DE BREVET EUROPEEN

(11) **EP 2 410 830 A1**
(43) Date de publication de la demande: **25.01.2012**
(21) Numéro de dépôt: 11174931.3
(22) Date de dépôt: 21.07.2011
(51) Int. Cl.: H05K 7/20

(54) **Dispositif de commande d'une pompe avec un dissipateur thermique**

(30) Priorité: 23.07.2010 FR 1056056
(71) Demandeur: Pompes Salmson, 78400 Chatou (FR)
(72) Inventeur: Hinard, Julien, 53000 Laval (FR); Bouilly, Hervé, 53940 Le Genest St Isle (FR); Maes, Sylvère, 53210 Louvigne (FR); Kernours, Michel, 35370 Mondevert (FR)
(74) Mandataire: Hirsch & Associés

(57) **Abrégé**

L'invention concerne un dispositif de commande d'une pompe de circulation de fluides, le dispositif (20) comprenant : un boîtier extérieur (22) ; une carte électronique (30) de commande de la pompe, logée à l'intérieur du boîtier (22) ; au moins un dissipateur thermique (40, 42) de la chaleur émise par la carte électronique (30) le dissipateur étant porté par le boîtier (22) ; un diélectrique (34) isolant électriquement le dissipateur thermique (40, 42) de la carte électronique (30), le diélectrique (34) assurant la conduction thermique entre la carte électronique (30) et le dissipateur thermique (40, 42) ; un organe de sollicitation (52) de la carte électronique (30) et du dissipateur thermique (40, 42) l'un vers l'autre, le diélectrique (34) étant sollicité en compression entre la carte électronique (30) et le dissipateur thermique (40, 42).

L'invention permet d'améliorer le transfert de chaleur entre l'électronique de commande et le dissipateur thermique.

## Description

L'invention se rapporte à un dispositif de commande d'une pompe de circulation de fluides. L'invention se rapporte en outre à une pompe de circulation de fluides et à une utilisation de la pompe de circulation de fluides pour la circulation d'eau chaude sanitaire ou de fluide de chauffage.

La pompe de circulation peut être utilisée dans des environnements où la température peut atteindre des valeurs élevées. Ainsi pour une utilisation de la pompe dans un circuit de chauffage, la température environnant la pompe peut typiquement atteindre 60°C lorsque la pompe est disposée à proximité de la chaudière du circuit de chauffage. Par ailleurs, le fluide véhiculé par la pompe peut aussi présenter des températures importantes de l'ordre de 110°C pour un fluide de chauffage, voir plus pour un fluide utilisée dans la récupération d'énergie solaire. Enfin, la pompe de circulation dégage elle-même de la chaleur de par le fonctionnement de son moteur d'entraînement.

Par ailleurs, on utilise classiquement de l'électronique de puissance pour commander le fonctionnement de la pompe. Pour des problèmes d'encombrement, l'électronique de commande de puissance est disposée au plus près du moteur d'entraînement de la pompe en circulation de fluides. Or ces composants électroniques de puissance peuvent dégager beaucoup de chaleur.

Comme l'environnement dans lequel se trouve la pompe est déjà particulièrement défavorable, la température de ces composants électroniques peut se révéler supérieure à la limite supportable et provoquer des disfonctionnements.

Il est alors connu de prévoir un dissipateur thermique pour évacuer la chaleur des composants chauds de l'électronique. Le dissipateur thermique est disposé sur le boîtier où sont logés les composants électroniques, le dissipateur thermique étant orienté vers l'extérieur du boîtier où l'air ambiant est plus froid qu'à l'intérieur du boîtier. La qualité de la transmission de la chaleur entre les composants électroniques et le dissipateur thermique limite cependant l'efficacité d'une telle solution.

Il existe donc un besoin pour un dispositif de commande d'une pompe de circulation améliorant le transfert de chaleur entre l'électronique de commande et un dissipateur thermique.

Pour cela, l'invention propose un dispositif de commande d'une pompe de circulation de fluides, le dispositif comprenant un boîtier extérieur, une carte électronique de commande de la pompe, logée à l'intérieur du boîtier, au moins un dissipateur thermique de la chaleur émise par la carte électronique, le dissipateur thermique étant porté par le boîtier, un diélectrique isolant électriquement le dissipateur thermique de la carte électronique, le diélectrique assurant la conduction thermique entre la carte électronique et le dissipateur thermique, un organe de sollicitation de la carte électronique et du dissipateur thermique l'un vers l'autre, le diélectrique étant sollicité en compression entre la carte électronique et le dissipateur thermique.

Selon une variante, au moins un dissipateur thermique est un dissipateur à ailettes.

Selon une variante, l'organe de sollicitation comprend une languette élastique solidaire du boîtier et/ou un joint d'étanchéité disposé entre le boîtier et le dissipateur à ailettes, l'élasticité de l'organe de sollicitation amenant le dissipateur à ailettes au contact du diélectrique par la sollicitation du dissipateur à ailettes vers la carte électronique.

Selon une variante, au moins un dissipateur thermique est un couvercle du boîtier extérieur.

Selon une variante, la carte électronique comporte des pistes électriques et un composant d'électronique de puissance soudé aux pistes électriques, le diélectrique étant fixé sur le composant électronique, l'organe de sollicitation amenant le diélectrique au contact du couvercle par la sollicitation de la carte électronique vers le couvercle.

Selon une variante, le diélectrique présente une épaisseur inférieure ou égale à 0,3mm en l'absence de sollicitation en compression.

Selon une variante, le dissipateur thermique est réalisé en aluminium.

L'invention se rapporte aussi à une pompe de circulation de fluides, comprenant un moteur d'entraînement de la pompe en circulation de fluides dans un moteur et un dispositif de commande de la pompe telle que décrite précédemment.

Selon une variante, le côté du dispositif présentant le dissipateur thermique fait face au moteur, l'assemblage du dispositif de commande au moteur maintenant le dissipateur thermique à distance du moteur.

Selon une variante, le fluide circulé par la pompe entre dans le moteur à une température supérieure ou égale à 90°C.

L'invention se rapporte aussi à l'utilisation de la pompe de circulation décrite précédemment pour la circulation d'eau chaude sanitaire ou pour la circulation d'un fluide de chauffage, particulièrement pour la circulation d'un fluide de chauffage dont la source de la chaleur est solaire ou géothermique.

D'autres caractéristiques et avantages de l'invention apparaîtront à la lecture de la description détaillée qui suit des modes de réalisation de l'invention, donnés à titre d'exemple uniquement et en références aux dessins qui montrent :
- figure 1, une vue de côté d'une pompe comprenant un dispositif de commande assemblé à un moteur de circulation de fluides ;
- figure 2, une vue éclatée en perspective de la pompe selon le mode de réalisation la figure 1 ;
- figure 3, une vue de dessus du dispositif de commande selon la figure 2, en coupe au niveau de la languette élastique du boîtier formant un organe de sollicitation ;
- figure 4, une vue agrandie de la languette élastique de la figure 3 ;
- figure 5, une vue agrandie d'un épaulement du dissipateur à ailettes recevant la languette élastique ;
- figure 6, une vue de dessus du dispositif de commande selon un autre mode de réalisation, en coupe au niveau du joint d'étanchéité entre le dissipateur à ailettes et le boîtier du dispositif de commande ;
- figure 7, une vue agrandie du joint d'étanchéité de la figure 6.

L'invention se rapporte à un dispositif de commande d'une pompe de circulation de fluides. Le dispositif comprend un boîtier extérieur et une carte électronique de commande de la pompe, logée à l'intérieur du boîtier. Le dispositif comprend aussi au moins un dissipateur thermique de la chaleur émise par la carte électronique, le dissipateur thermique étant porté par le boîtier.

Par ailleurs le dispositif de commande comprend un diélectrique isolant électriquement le dissipateur thermique de la carte électronique pour éviter tout court circuit ou toute autre défaillance électrique des composants électroniques de la carte. Ce diélectrique est disposé entre la carte électronique et le dissipateur thermique pour assurer la conduction thermique entre la carte électronique et le dissipateur thermique. Le diélectrique permet aussi de compenser la rugosité des deux éléments pour assurer un meilleur contact entre les éléments.

Le dispositif comprend en outre un organe de sollicitation de la carte électronique et du dissipateur thermique l'un vers l'autre. L'organe de sollicitation permet un mouvement relatif de la carte électronique et du dissipateur thermique l'un vers l'autre. La sollicitation entraîne la sollicitation (ou maintien) du diélectrique en compression.

La sollicitation en compression du diélectrique entraîne, d'un côté du diélectrique un bon contact thermique avec la carte électronique, et de l'autre côté du diélectrique un bon contact thermique avec le dissipateur. La réalisation de bons contacts thermiques participe à l'obtention d'un meilleur transfert de la chaleur de la carte électronique au dissipateur thermique.

De plus du fait de la sollicitation l'un vers l'autre de la carte électronique et du dissipateur thermique, le maintien en compression du diélectrique est indépendant de l'épaisseur du diélectrique ainsi que des tolérances de fabrication des différentes pièces du dispositif. L'organe de sollicitation ajuste en effet la distance séparant le dissipateur et la carte électronique à l'épaisseur du diélectrique. L'utilisation de l'organe de sollicitation permet alors de s'affranchir de l'utilisation de diélectrique dont l'épaisseur est adaptable à la distance séparant le dissipateur et la carte électronique du fait des tolérances de fabrication des différentes pièces. Le dispositif proposé assure ainsi de bons contacts thermiques en évitant notamment l'utilisation de ces diélectriques à épaisseur adaptable, comme par exemple les mousses thermiques, qui présentent une forte résistance thermique détériorant le transfert thermique.

En définitive le dispositif proposé permet d'améliorer le transfert de chaleur entre l'électronique de commande et le dissipateur thermique.

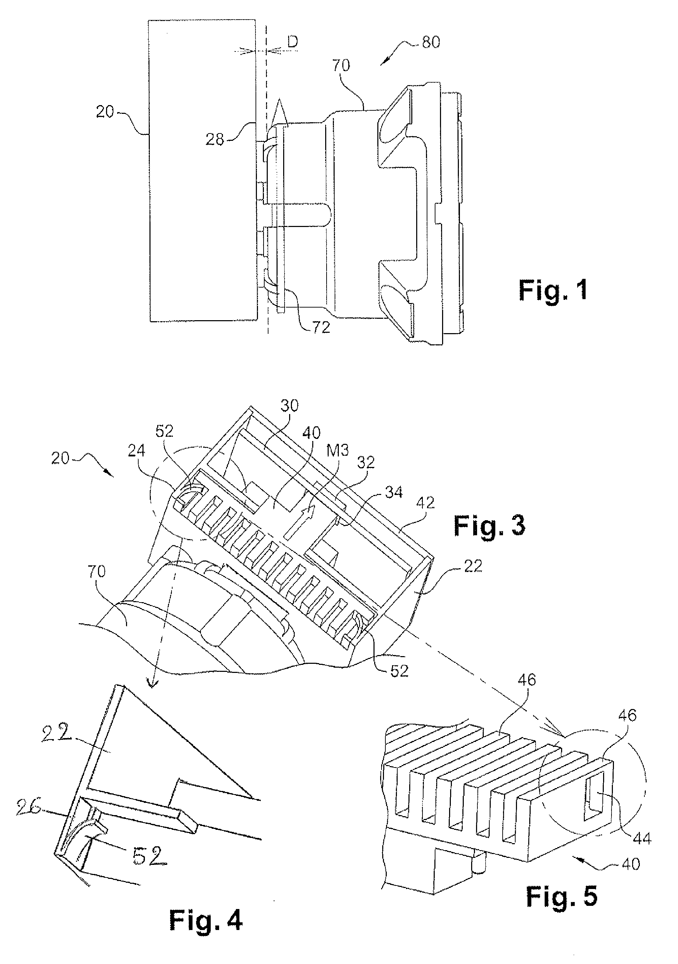

La figure 1 montre une pompe 80 de circulation de fluide comprenant un moteur 70. La pompe 80 comprend en outre le dispositif de commande proposé 20.

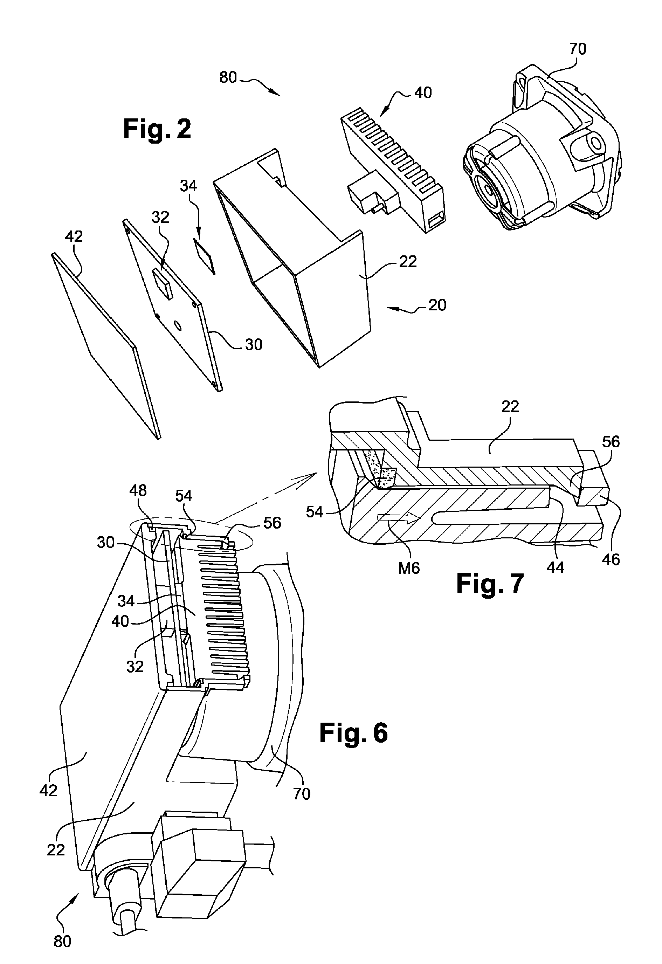

La figure 2 montre une vue éclatée en perspective de la pompe selon le mode de réalisation précédent. Le dispositif de commande 20 comporte un boîtier extérieur ou boîtier de commande 22.

Le boîtier extérieur 22 loge la carte électronique 30 du dispositif de commande 20. La carte électronique 30 correspond à un circuit imprimé (en anglais *printed circuit board,* en abrégé PCB) supportant des composants électroniques. Cette carte électronique 30 comporte des pistes électriques et entre autres un composant électronique 32 soudé aux pistes électroniques de manière connue en soi. Le composant électronique 32 est un module électronique de puissance (connu sous le nom de *Intelligent Power Module* en anglais, en abregé IPM) commandant la puissance électrique à fournir au moteur d'entraînement de la pompe 80. Ce module est traversé par des courants électriques permettant l'entraînement de la pompe. Les courants électriques sont ainsi de grande intensité, ce qui entraîne un dégagement de chaleur par le composant électronique 32 par l'effet Joule.

Le boîtier extérieur 22 porte un dissipateur à ailettes 40 et un couvercle 42, c'est-à-dire que le couvercle 42 et le dissipateur à ailettes 40 ne sont pas fixés sur la carte électronique 30. Le dissipateur à ailettes 40 et le couvercle 42 sont en effet solidaires du boîtier 22 indépendamment de la présence de la carte électronique 30 dans le boîtier 22. Ceci permet de réaliser facilement l'étanchéité avec le boîtier extérieur 22. L'utilisation d'un couvercle 42 permet d'assurer une fermeture définitive après assemblage, ainsi que l'étanchéité du boîtier.

Le couvercle 42 et le dissipateur à ailettes 40 constituent des modes de réalisation possibles du dissipateur thermique pour le dispositif de commande 20. La réalisation du couvercle 42 et du dissipateur à ailettes 40 est de préférence en aluminium pour permettre une amélioration des performances de dissipation thermique. Le couvercle 42 et le dissipateur à ailettes 40 sont tous deux portés par le boîtier 22 pour permettre l'échange de chaleur entre l'intérieur du boîtier 22 et l'extérieur du boîtier 22. La suite de la description du dispositif de commande 20 est illustrée avec le couvercle 42 et le dissipateur à ailettes 40 sans limiter la réalisation du dispositif de commande proposé 20 à ces deux modes particuliers de réalisation du dissipateur thermique.

Le boîtier extérieur 22 loge en outre le diélectrique 34 assurant la conduction thermique entre la carte électronique 30 et le dissipateur à ailettes 40.

La figure 3 montre une vue de dessus du dispositif de commande précédent 20. Cette vue constitue une coupe du dispositif de commande 20 au niveau du dissipateur à ailettes 40. Le diélectrique 34 est disposé entre la carte électronique 30 et le dissipateur à ailettes 40. Le diélectrique 34 est au contact de la carte électronique 30 au niveau du composant électronique 32. Plus particulièrement dans le mode de réalisation ici illustré, le diélectrique 34 est en contact avec des pistes de la carte électronique elles-mêmes reliées au composant électronique 32 (à travers la carte), permettant ainsi un transfert de chaleur du composant électronique 32 vers le dissipateur 40. La carte de la figure 3 peut comporter plusieurs couches de pistes (par exemple une sur chaque face de la carte et une ou descouches de pistes intermédiaires). Le composant électronique 32 est soudé en surface sur la face non visible de la carte de la figure 3 et les pistes sont reliées à la face visible de la carte par des « vias » (qui sont des trous métallisés pour passer d'une piste d'une couche à une autre, et donc transférer la chaleur d'une face de la carte à l'autre).

Le boîtier 22 présente des languettes élastiques 52. Les languettes élastiques 52 sont solidaires du boîtier 22. La figure 4 montre une vue agrandie du boîtier 22 au niveau d'une des languettes élastiques 52. Dans ce mode de réalisation, la languette 52 est venue de matière avec le boîtier 22. Le boîtier 22 peut être réalisé en plastique. La languette élastique 52 peut être obtenue avec le boîtier 22 par moulage. La languette élastique 52 est solidaire du boîtier 22 au niveau d'une arête externe 24 du boîtier 22, et s'étend vers l'intérieur du boîtier 22 en se détachant progressivement de la paroi 26 du boîtier 22. Les languettes constituent des pinces formant un ressort (ou clip).

La languette élastique 52 coopère avec le dissipateur à ailettes de manière à amener le dissipateur à ailettes 40 au contact du diélectrique 34. L'élasticité de la languette 52 permet un mouvement du dissipateur thermique vers la carte électronique et ainsi d'ajuster la distance entre le dissipateur à ailettes 40 et la carte électronique 30 à l'épaisseur du diélectrique 34. En conséquence la languette élastique 52 est un mode de réalisation possible de l'organe de sollicitation du dispositif de commande 20.

La languette élastique 52 peut coopérer avec le dissipateur à ailettes 40 par l'intermédiaire de l'épaulement 44 représenté en vue agrandie par la figure 5. L'épaulement 44 est ici aménagé dans l'épaisseur d'une des ailettes 46 du dissipateur à ailettes 40. Plus particulièrement l'épaulement 44 est aménagé dans une des ailettes 46 disposée à l'extrémité du dissipateur à ailettes 40. Une telle coopération simplifie la réalisation de la sollicitation du dissipateur à ailettes 40 vers la carte électronique 30.

Par ailleurs la configuration des languettes élastiques 52 selon la figure 3 permet d'obtenir un montage simplifié du dispositif 20 avec le dissipateur à ailettes 40 munis des épaulements 44. Le dissipateur à ailettes 40 est inséré dans le boîtier 22. Lors de l'insertion du dissipateur à ailettes 40 dans le boîtier 22, les ailettes 46 aux extrémités du dissipateur à ailettes forcent les languettes 52 contre la paroi 26. Les languettes 52 sont alors escamotables, et sont maintenues contre la paroi 26 jusqu'à ce que le dissipateur à ailettes 40 soit suffisamment inséré dans le boîtier 22 pour que les épaulements 44 dépassent la position des languettes élastiques 52. Les languettes élastiques 52 s'éloignent alors de la paroi 26 et s'appuient contre dissipateur à ailettes en 40 en sollicitant le dissipateur à ailettes 40. Le diélectrique 34 peut être fixé sur la carte électronique 30 ou sur le dissipateur. La carte 30 peut être ensuite fixée dans un logement adapté à l'intérieur du boîtier 22, dans une position conforme à celle la figure 3. La flèche M3 sur la figure 3 montre la sollicitation du dissipateur à ailettes 40 vers la carte électronique 30, maintenant ainsi le diélectrique 34 en compression. Les languettes 52 réalisent une fonction ressort permettant d'adapter la distance entre le dissipateur à ailettes 40 et la carte électronique 30.

La figure 6 montre une vue de dessus du dispositif de commande 20 selon un autre mode de réalisation de l'organe de sollicitation. La vue du dispositif de commande 20 est réalisée en coupe au niveau du dissipateur à ailettes 40. Le boîtier 22 loge la carte électronique 30 sur laquelle est soudée le composant électronique 32. Le diélectrique 34 est intercalé entre la carte 30 et le dissipateur à ailettes 40. Un joint d'étanchéité 54 est prévu pour assurer l'étanchéité entre le boîtier 22 et le dissipateur à ailettes 40, alors qu'un joint d'étanchéité 48 est prévu pour assurer l'étanchéité entre le boîtier 22 et le couvercle du boîtier 42. Les joints d'étanchéité 54 et 48 peuvent aussi être prévus dans le mode de réalisation conforme à la figure 3. Ces joints permettent d'isoler l'électronique de toute fuite de fluide circulé par la pompe.

La figure 7 montre une vue agrandie du dissipateur à ailettes 40 au niveau du joint d'étanchéité 54. Le dissipateur à ailettes 40 est logé dans le boîtier 22 par coopération de la dent 56 reçue dans le logement 44. Dans ce mode de réalisation, le dissipateur à ailettes 40 est logé dans le boîtier 22 en étant inséré depuis l'intérieur du boîtier 22 vers l'extérieur du boîtier 22 (dans le sens de la flèche M6). Dans ce mouvement d'insertion, les ailettes 46 des extrémités du dissipateur à ailettes 40, forcent les dents 56 vers l'extérieur, jusqu'à ce que les logements 44 soient disposés en face des dents 56. Les dents 56 sont alors reçues dans les logements 44 limitant le mouvement du dissipateur à ailettes dans le sens inverse de l'insertion de montage précédent. Ce n'est qu'une fois que le dissipateur à ailettes 40 a été inséré que la carte 30 est logée dans le boîtier 22.

La disposition de la carte 30 dans sa position de montage à l'intérieur du boîtier 22 impose un mouvement du dissipateur à ailettes dans le sens de la flèche M6 (de l'intérieur du boîtier 22 vers l'extérieur). L'élasticité du joint 54 s'oppose alors à ce mouvement et en réaction le joint 54 sollicite le dissipateur à ailettes 40 vers la carte 30 (de l'extérieur vers l'intérieur du boîtier 22, dans le sens inverse de la flèche M6). Le diélectrique 34 disposé entre le dissipateur à ailettes 40 et la carte 30 est alors sollicité en compression ce qui permet d'assurer de bons contacts thermiques et en définitive d'obtenir un bon transfert thermique entre la carte électronique 30 et le dissipateur à ailettes 40. Le joint d'étanchéité 54 constitue un mode de réalisation possible de l'organe de sollicitation de la carte électronique 30 et du dissipateur à ailettes 40 l'un vers l'autre.

Dans le cas où le couvercle 42 est utilisé en tant que dissipateur thermique, le diélectrique 34 peut être disposé entre le composant 32 et le couvercle 42 (mode de réalisation non illustré). Le diélectrique 34 est fixé préalablement sur le couvercle 42 ou sur le composant 32. Dans ce mode de réalisation, l'organe de sollicitation peut être réalisé par le système de réception (non représenté) de la carte électronique 30 dans le boîtier 22. Le système de réception présente alors une élasticité permettant d'ajuster la distance entre la carte électronique 30, une fois reçue dans le boîtier 22, et le couvercle 42 porté par boîtier 22 de manière fixe. L'élasticité du système de réception peut être simplement fournie par une mousse élastique précontrainte (non illustré) poussant la carte électronique 30 vers le couvercle 42, c'est-à-dire sollicitant la carte électronique 30 de l'intérieur du boîtier 22 vers l'extérieur. La mousse élastique réalise une fonction ressort. Dans ce mode de réalisation, il est préférable de prévoir des connexions électriques flexibles entre le boîtier 22 et la carte électronique pour pouvoir absorber le déplacement de la carte 30 vers le couvercle 42.

Le mode de réalisation avec le diélectrique 34 disposé entre la carte électronique 30 et le couvercle 42 est alternatif ou complémentaire du mode de réalisation avec le diélectrique 34 disposé entre la carte électronique 30 et le dissipateur à ailettes 40. En effet l'utilisation des deux dissipateurs thermiques 40 et 42 avec l'utilisation de deux diélectriques 34 permet d'améliorer la dissipation thermique de la chaleur provenant de la carte électronique 30. Selon les figures 3 et 6, la combinaison de ces deux modes de réalisation implique une disposition des différentes pièces de la manière suivante, dans l'ordre :
- le dissipateur à ailettes 40 sollicité vers la carte électronique 30, le premier diélectrique 34 étant sollicité en compression entre le dissipateur à ailettes 40 et la carte électronique 30 ;
- la carte électronique 30 sollicitée vers le couvercle 42, le deuxième diélectrique 34 étant sollicité en compression entre la carte électronique 30 et le couvercle 42.

L'organe de sollicitation peut être choisi parmi les modes de réalisations de l'organe de sollicitation précédemment décrit (les languettes élastiques 52, le joint d'étanchéité 54 et le système de réception élastique de la carte 30), pris seul ou en combinaison. Le choix d'un seul des ces modes de réalisation de l'organe de sollicitation suffit à la sollicitation en compression des deux diélectriques 34, permettant ainsi une fabrication simplifié du dispositif de commande 20.

Tel que précédemment mentionné la sollicitation l'un vers l'autre de la carte électronique 32 et du dissipateur thermique 40 ou 42 assure que le maintien en compression du diélectrique est indépendant de l'épaisseur du diélectrique 34 ainsi que des tolérances de fabrications des pièces du dispositif 20. L'épaisseur du diélectrique et les tolérances son compensées par translation relative de la carte 30 vers le dissipateur 40 ou 42.

Ainsi dans le cas où les tolérances de fabrication du boîtier 22 sont par exemple de l'ordre de 0,2mm, la sollicitation de la carte électronique 30 et du dissipateur thermique 40 ou 42 l'un vers l'autre permet d'absorber les 0,4 mm de tolérance (0,2 mm de tolérance au niveau de la réception de la carte 30 dans le boîtier 22 et 0,2 mm de tolérance là où le dissipateur thermique est porté par le boîtier 22). Le dispositif de commande 20 proposé en absorbant les tolérances de construction permet d'obtenir une fabrication moins coûteuse par diminution des exigences de tolérance. Dans le mode de réalisation de l'organe de sollicitation avec le système de réception de la carte 30 muni d'une mousse élastique, la mousse élastique présente de préférence une longueur de déformation en compression supérieure ou égale à 1mm.

L'indépendance vis-à-vis de l'épaisseur du diélectrique 34 permet de choisir un diélectrique 34 d'épaisseur la plus faible possible, par exemple inférieure ou égale à 0,3mm. La faiblesse de l'épaisseur diminue la résistance thermique du diélectrique et améliore ainsi le transfert thermique.

Le dispositif 20 proposé permet l'utilisation de produits commercialisé sous la marque Sil-Pad ® dont la dureté est supérieure à 70 shore A. De tels produits permettent un très bon transfert thermique lorsque les contacts thermiques sont maintenus par sollicitation en compression tel que dans le dispositif de commande proposé 20. Le diélectrique 34 est ainsi rigide en comparaison de l'organe de sollicitation réalisant une fonction ressort. L'épaisseur du diélectrique rigide 34 varie de façon négligeable entre la situation où le diélectrique est sollicité en compression et la situation où il n'y a pas de sollicitation du diélectrique 34. Cette variation négligeable de l'épaisseur ne permet pas à elle seule de compenser les tolérances de construction.

De retour à la figure 1, le dispositif de commande 20 est assemblé au moteur 70, avec un côté 28 du dispositif de commande 20 qui est maintenu à une distance D du moteur 70. Le maintien de la distance D assure la circulation d'un courant 72 de convection d'air entre le moteur 70 et forme ainsi une barrière thermique (ou air-gap) de part les propriétés isolantes de l'air entre le dispositif de commande et le moteur. Il est alors préféré que le côté 28 du dispositif de commande 20 présente le dissipateur thermique 40 ou 42 à des fins d'esthétique. Egalement, il y a plus de place pour le dissipateur sur ce côté 28 et donc une meilleure efficacité de manière à transférer la chaleur du composant 32 jusqu'au courant 72 de convection d'air extérieur. Le dissipateur thermique 40 ou 42 peut alors être situé partiellement ou en totalité dans le courant 72 de convection d'air.

L'amélioration du transfert thermique par le dispositif de commande proposé permet à la pompe 80 de faire circuler un fluide entrant dans le moteur 70 à des températures de fluides élevées (pouvant être supérieur à 90°C) dans un environnement également chaud (pouvant atteindre 60°C), sans endommager thermiquement la carte électronique 30 où les composants électroniques 32 tel qu'un IPM. Il est ainsi possible d'utiliser la pompe 80 pour la circulation d'eau chaude sanitaire ou pour la circulation d'un fluide de chauffage. Il est particulièrement avantageux d'utiliser la pompe 80 proposé pour la circulation d'un fluide de chauffage dont la source de la chaleur est solaire ou géothermique, ces sources de chauffage imposant des températures élevées au fluide de chauffage.

Bien entendu, la présente invention n'est pas limitée aux exemples et aux modes de réalisation décrits et représentés, mais elle est susceptible de nombreuses variantes accessibles à l'homme de l'art.

## Revendications

1. Dispositif de commande d'une pompe de circulation de fluides, le dispositif (20) comprenant :
- un boîtier extérieur (22) ;
- une carte électronique (30) de commande de la pompe, logée à l'intérieur du boîtier (22) ;
- au moins un dissipateur thermique (40, 42) de la chaleur émise par la carte électronique (30), le dissipateur thermique (40, 42) étant porté par le boîtier (22) ;
- un diélectrique (34) isolant électriquement le dissipateur thermique (40, 42) de la carte électronique (30), le diélectrique (34) assurant la conduction thermique entre la carte électronique (30) et le dissipateur thermique (40, 42) ;
- un organe de sollicitation (52, 54) de la carte électronique (30) et du dissipateur thermique (40, 42) l'un vers l'autre, le diélectrique (34) étant sollicité en compression entre la carte électronique (30) et le dissipateur thermique (40, 42).

2. Dispositif de commande selon la revendication 1, dans lequel au moins un dissipateur thermique (40, 42) est un dissipateur à ailettes (40).

3. Dispositif de commande selon la revendication 2, l'organe de sollicitation (52, 54) comprenant une languette élastique (52) solidaire du boîtier (22) et/ou un joint d'étanchéité (54) disposé entre le boîtier (22) et le dissipateur à ailettes (40), l'élasticité de l'organe de sollicitation (52, 54) amenant le dissipateur à ailettes (40) au contact du diélectrique (34) par la sollicitation du dissipateur à ailettes (40) vers la carte électronique (30).

4. Dispositif de commande selon l'une des revendications 1 à 3, dans lequel au moins un dissipateur thermique (40, 42) est un couvercle (42) du boîtier extérieur (22).

5. Dispositif de commande selon la revendication 4, dans lequel la carte électronique (30) comporte des pistes électriques et un composant d'électronique de puissance (32) soudé aux pistes électriques, le diélectrique (34) étant fixé sur le composant électronique (32), l'organe de sollicitation (52, 54) amenant le diélectrique (34) au contact du couvercle (42) par la sollicitation de la carte électronique (30) vers le couvercle (42).

6. Dispositif de commande selon l'une des revendications 1 à 5, dans lequel le diélectrique (34) présente une épaisseur inférieure ou égale à 0,3mm en l'absence de sollicitation en compression.

7. Dispositif de commande selon l'une des revendications 1 à 6, dans lequel le dissipateur thermique (40, 42) est réalisé en aluminium.

8. Pompe de circulation de fluides, comprenant un moteur d'entraînement de la pompe (80) en circulation de fluides dans un moteur (80) et un dispositif de commande (20) de la pompe selon l'une des revendications 1 à 7.

9. Pompe de circulation selon la revendication 8, dans laquelle le côté (28) du dispositif (20) présentant le dissipateur thermique fait face au moteur (70), l'assemblage du dispositif de commande (20) au moteur (70) maintenant le dissipateur thermique à distance (D) du moteur (70).

10. Pompe de circulation selon la revendication 8 ou 9, dans laquelle le fluide circulé par la pompe (80) entre dans le moteur (70) à une température supérieure ou égale à 90°C.

11. Utilisation de la pompe de circulation (80) selon l'une des revendications 8 à 10 pour la circulation d'eau chaude sanitaire ou pour la circulation d'un fluide de chauffage, particulièrement pour la circulation d'un fluide de chauffage dont la source de la chaleur est solaire ou géothermique.
